# EUROPÄISCHE PATENTSCHRIFT

(11) **EP 2 455 959 B1**
(45) Veröffentlichungstag und Bekanntmachung des Hinweises auf die Patenterteilung: **06.03.2013**
(21) Anmeldenummer: 10191330.9
(22) Anmeldetag: 16.11.2010
(51) Int. Cl.: H01H 36/00, H03K 17/955

(54) **Schaltvorrichtung für ein medizinisches Gerät und Verfahren zum Betrieb der Schaltvorrichtung**
Switching device for a medical appliance and method for operating switching device
Dispositif de commutation pour un appareil médical et procédé de fonctionnement du dispositif de commutation

(43) Veröffentlichungstag der Anmeldung: 23.05.2012
(73) Patentinhaber: TRUMPF Medizin Systeme GmbH + Co. KG, 07318 Saalfeld (DE)
(72) Erfinder: Geiger, Peter, 72800 Eningen (DE); Krause, Olaf, 16816 Neuruppin (DE); Löser, Steffen, 07333 Unterwellenborn OT Goßwitz (DE); Georgi, Falk, 07422 Saalfelder Höhe (DE); Sasse, Joachim, 14612 Falkensee (DE)
(74) Vertreter: Prüfer & Partner GbR European Patent Attorneys

(56) Entgegenhaltungen:
- EP-A1- 2 113 268
- EP-A2- 1 758 137
- WO-A1-2004/098083
- GB-A- 2 465 472
- US-A1- 2010 038 227

## Beschreibung

Die Erfindung bezieht sich auf eine Schaltvorrichtung für ein medizinisches Gerät, insbesondere auf eine Schaltvorrichtung für einen Operationstisch, wobei die Schaltvorrichtung eine Einrichtung zur Erzielung einer Erstfehlersicherheit aufweist, die ergonomisch zu bedienen ist.

Die Offenlegungsschrift EP 2 113 268 A1 offenbart ein medizinisches Gerät, das einen berührungslosen Sensor oder einen Berührungssensor aufweist, der beispielsweise von einem geerdeten Finger betätigt wird. Dieser Sensor kann einen benachbarten Druckknopf oder ein Display aktivieren.

Die Offenlegung der Patentanmeldung WO 2004/098083 A1 beschreibt ein Mobiltelefon, das mit einer Taste versehen sein kann, die alternativ über einen mechanischen Schalter eine Schaltfunktion ausübt oder mit Hilfe eines berührungslosen oder berührenden Sensors den Fingerabdruck eines Bedieners erkennt und dann eine Schaltfunktion ausführt.

Das Dokument US 2010/0038227 A1 zeigt ein zweistufiges Tastenfeld, dessen Tasten jeweils einen Sensor und einen Schalter aufweisen. Durch Annähern eines Objekts, beispielsweise eines Fingers, wird eine Ansteuereinheit durch den Sensor dazu veranlasst, durch eine Sprachausgabe über Funktion der Taste zu informieren. Beim Drücken der Taste wird die Funktion dann ausgeführt.

Die Patentanmeldung GB 2465472 A offenbart eine Druckknopfeinheit für einen Vergnügungsapparat, die Annäherungssensoren und einen elektromechanischen Schalter aufweist. Mit dem elektromechanischen Schalter können Eingaben in den Verqnügungsapparat ausgeführt werden und mit den Annäherungssensoren können ebenfalls Eingaben, wie z.B. ein Umschalten eines Betriebsmodus, oder ein Ausführen von Beleuchtungs-, Animations- oder Klangeffekten ausgelöst werden.

Medizinische Geräte, insbesondere aktive Medizinprodukte, die mit Hilfe einer Energie, die nicht durch Schwerkraft oder Muskelkraft bereitgestellt wird, betrieben werden, müssen eine Erstfehlersicherheit aufweisen, um im Fall von sicherheitskritischen Funktionen die Sicherheit von Patienten, Bedienern und Dritten nicht zu gefährden. Zu dieser Erstfehlersicherheit gehört im Falle von Schaltvorrichtungen, mit denen Bedienfunktionen für ein medizinisches Gerät geschaltet werden, zum einen, dass dieses Funktionen nicht unbeabsichtigt geschaltet werden können, und zum anderen, dass, falls ein Fehler in der Schaltvorrichtung vorhanden ist, dieser Fehler erkannt wird.

Das unbeabsichtigte Schalten der Bedienfunktionen wird meist über die Bedienung von zwei elektromechanischen Schaltern, die räumlich voneinander getrennt sind, verhindert. Durch die räumliche Trennung wird aber die Bedienung erschwert, wobei sich auch die Bedienkraft erhöht, falls die beiden Schalter doch mit einer Hand betätigt werden, und die Zuverlässigkeit der Bedienung wird verringert, da die beiden getrennten Schalter betätigt sein müssen.

Weiterhin besteht die Gefahr, dass bei der Verwendung von zwei gleichartigen Schaltern mit gleichen Schaltprinzipien beim Vorliegen eines Fehlerfalls, z.B. mechanische Beschädigung oder Verschütten von Flüssigkeiten, beide Schalter beschädigt werden können und dann fehlerhaft durchschalten, insbesondere, wenn diese aus ergonomischen Gründen in unmittelbarer Nähe zueinander angeordnet sind.

Ein Fehler von einem der Schalter, wie z.B. ein Verkleben der Kontakte, wird dabei auch nicht sofort, also nicht beim Loslassen des Schalters, erkannt.

Daraus ergibt sich die Aufgabe, eine Schaltvorrichtung für ein medizinisches Gerät bereitzustellen, die ergonomisch zu bedienen ist und die zuverlässig eine Erstfehlersicherheit gewährleistet.

Die Aufgabe wird durch einen Gegenstand mit den Merkmalen des Anspruchs 1 und ein Verfahren mit den Merkmalen des Anspruchs 15 gelöst. Weiterentwicklungen der Erfindung sind Gegenstanα der abhängigen Ansprüche.

Ein Aspekt einer Schaltvorrichtung für ein medizinisches Gerät zum Erreichen einer Erstfehlersicherheit ist, dass die Schaltvorrichtung mindestens ein erstes Schaltelement, das eine Bedienfunktion des medizinischen Geräts schaltet, und mindestens ein zweites Schaltelement, das eine Schaltfunktion des mindestens ersten Schaltelements freigibt, aufweist, wobei das Schalten der ersten und zweiten Schaltelemente auf verschiedenen Schaltprinzipien beruht, und das zweite Schaltelement einen Erfassungsraum aufweist, in dem eine Anwesenheit eines Betätigungsobjekts erfasst wird, und mindestens eines der ersten Schaltelemente in dem Erfassungsraum von mindestens einem der zweiten Schaltelemente angeordnet ist.

Die Erfindung wird nun unter Bezugnahme auf die beigefügten Zeichnungen anhand eines Ausführungsbeispiels näher erläutert.

Im Einzelnen zeigen:
- Fig. 1: ein medizinisches Gerät in Form eines Operationstischs und eine Schaltvorrichtung des medizinischen Geräts in Form einer Fernbedienung;
- Fig. 2a: die Schaltvorrichtung in einer perspektivischen Ansicht ohne Symbole für Bedienfunktionen;
- Fig. 2b: die Schaltvorrichtung in einer perspektivischen Ansicht mit Symbolen für Bedienfunktionen;
- Fig. 3: eine Explosionsdarstellung der Schaltvorrichtung;
- Fig. 4a: einen Abschnitt eines Querschnitts durch die in Fig. 3 gezeigte Schnittlinie A-A mit einer ersten Schaltvorrichtung; und
- Fig. 4b: den Abschnitt des Querschnitts durch die in Fig. 3 gezeigte Schnittlinie A-A mit einer zweiten Schaltvorrichtung.

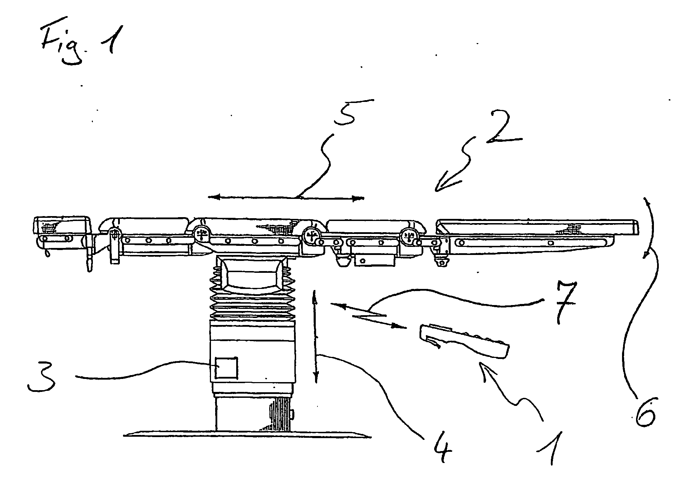

Fig. 1 zeigt eine Schaltvorrichtung 1 für ein medizinisches Gerät 2. Die Schaltvorrichtung 1 ist hier als Fernbedienung für das medizinische Gerät 2 in Form eines Operationstischs ausgebildet. Der Operationstisch weist eine Steuerungsvorrichtung 3 auf, die ausgebildet ist, Funktionen des medizinischen Geräts 2, wie zum Beispiel einen Antrieb für Höhenverstellung 4, einen Antrieb für Längsverschiebung 5 und einen Antrieb für ein Schwenken 6 anzusteuern. Die Steuerungsvorrichtung 1 ist über eine drahtlose Datenverbindung 7 mit dem medizinischen Gerät verbunden, über die Befehle für die Bedienfunktionen, z.B. die Höhenverstellung, die Längsverschiebung oder das Schwenkens an die Steuerungsvorrichtung 3 des medizinischen Geräts 2 gegeben werden.

Die Schaltvorrichtung 1 ist hier als Fernbedienung ausgebildet, kann jedoch auch in das medizinische Gerät 2 integriert sein, oder an einer anderen geeigneten Stelle, z.B. an der Wand oder in einer medizinischen Versorgungseinheit, vorgesehen sein. Die Datenverbindung 7 wird hier in Form einer kombinierten Infrarot-und Funkverbindung realisiert. Alternativ kann auch nur eines der beiden Prinzipien verwendet werden, oder die Befehle auf eine andere Weise übertragen werden. Es ist auch nicht zwingend erforderlich, dass die Befehle für die Bedienfunktionen wie hier drahtlos übertragen werden, sondern eine drahtgebundene Verbindung zwischen der Schaltvorrichtung 1 und der Steuerungsvorrichtung 3 des medizinischen Geräts 2, insbesondere bei einer in das medizinische Gerät 2 integrierten Schaltvorrichtung 1, ist ebenfalls möglich.

Weitere medizinische Geräte 2, für die die Schaltvorrichtung 1 verwendet werden kann, sind z.B. Operationsleuchten, Anästhesiegeräte, medizinische Versorgungseinheiten und sonstige Geräte, bei denen ein fehlerhaftes Schalten zu einer Gefährdung für einen Patienten, Bediener oder Dritten führen kann.

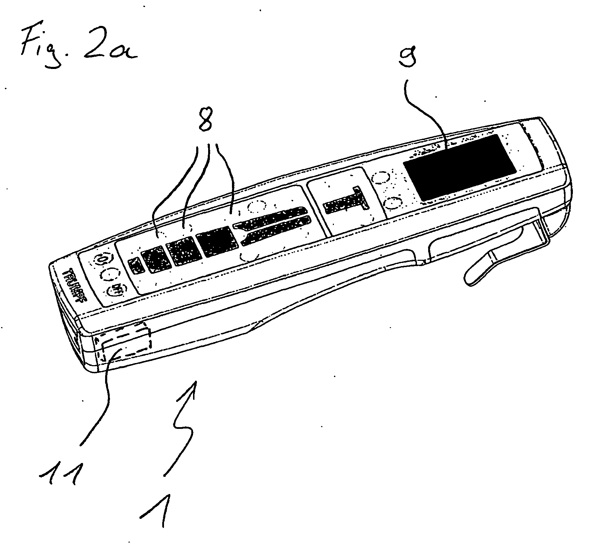

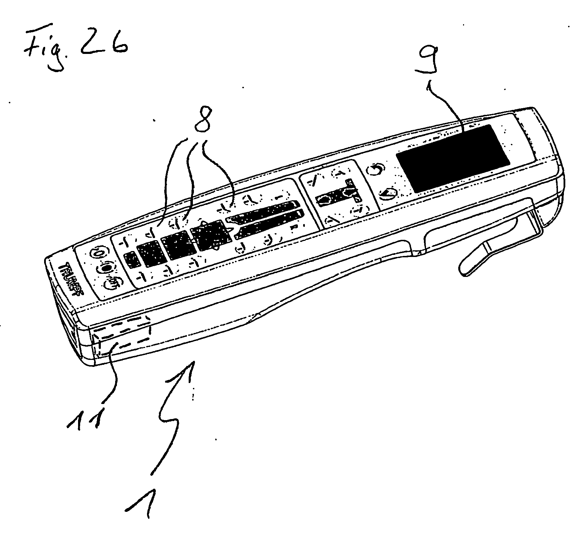

In den Figuren 2 ist die Schaltvorrichtung 1 in einer perspektivischen Ansicht gezeigt. In Fig. 2a und Fig. 2b ist auf der Oberseite der Schaltvorrichtung 1 eine Mehrzahl von später beschriebenen Tasten 8 vorgesehen. Auf den Tasten ist, wie in Fig. 2b gezeigt, jeweils ein entsprechendes Symbol für eine zugeordnete Bedienfunktion zeitweise angezeigt. Angezeigt werden nur diejenigen Symbole der Bedienfunktionen, die aufgrund der Konfiguration des medizinischen Geräts 2, also der Konfiguration des OP-Tischs mit verschiedenen Lagerungsplattenelementen, möglich sind, und die aufgrund der derzeitigen Stellung des Operationstischs zulässig sind, so dass zum Beispiel verhindert wird, dass der Operationstisch kippt.

An der Schaltvorrichtung 1 (in den Figuren 2 auf der rechten Seite) ist ein Touchscreen 9 vorgesehen, mit dem grundsätzliche Einstellungen des medizinischen Geräts 2, wie zum Beispiel eine Geschwindigkeitsvorwahl, eingestellt werden können. Weiterhin ist es durch den Touchscreen 9 auch möglich, beispielsweise ein Endoskopielicht am Operationstisch einzuschalten, Positionen der einzelnen Lagerflächenelemente abzuspeichern, oder auch andere medizinische Geräte, wie zum Beispiel eine Operationsleuchte, anzusteuern.

Weiterhin ist in der Schaltvorrichtung 1, wenn sie als Fernbedienung vorgesehen ist, ein Lage-/Beschleunigungssensor 11 vorhanden. Durch den Lage-/Beschleunigungssensor 11 wird erkannt, ob die Fernbedienung bewegt wird, wodurch beispielsweise ein Aktivieren der Fernbedienung aus einem Standby-Zustand erfolgen kann. Des Weiteren kann die Fernbedienung so konfiguriert sein, dass, solange der Lage-/Beschleunigungssensor 11 eine Bewegung erkennt, die Fernbedienung aktiv bleibt und nicht in den Standby-Zustand zurückkehrt.

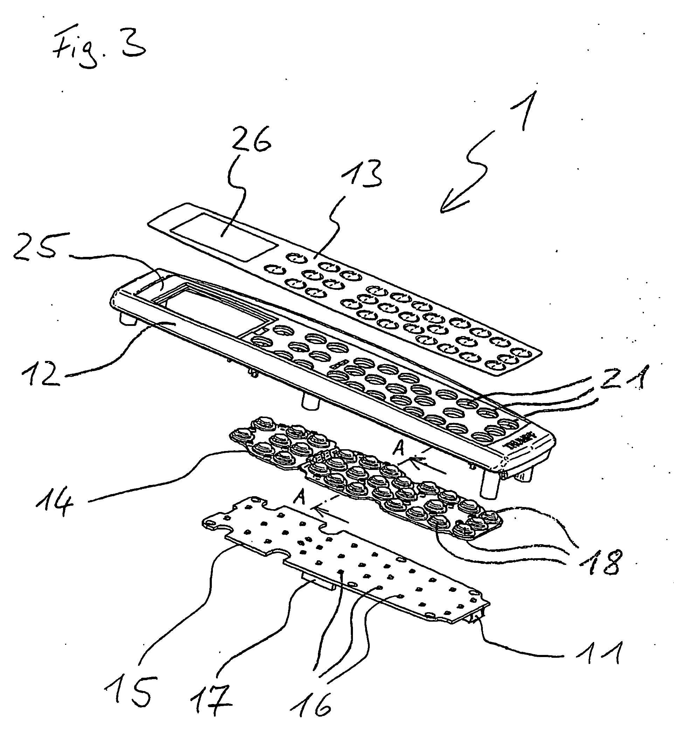

Die in Fig. 3 als eine Explosionsdarstellung gezeigte Schaltvorrichtung 1 weist u.a. eine Oberschale 12, eine Folie 13, eine Schaltmatte 14 und eine Leiterplatte 15 auf.

Die Oberschale 12 ist aus einem desinfektionsmittelbeständigen Kunststoff angefertigt, und bildet einen oberen Teil eines Gehäuses der Fernbedienung als die Schaltvorrichtung 1. Die Oberschale 1 weist eine Vertiefung 25 auf, in die die Folie 13 eingebracht und mit der Oberschale 12 verbunden wird. An den Stellen, an denen auf der Fernbedienung Tasten 8 (siehe Fig. 2) vorgesehen sind, sind in der Oberschale später beschriebene Durchgangslöcher 21 vorgesehen. In Fig. 3 im linken Bereich ist in der Oberschale die Öffnung für den Touchscreen 9 vorgesehen. An der Unterseite der Oberschale 12 sind vier Dome dargestellt, über die die Oberschale 12 mit einer nicht gezeigten Unterschale aus dem gleichen Material verbunden wird.

Die Folie 13 dient zum einen als Schutz- und Dekorfolie. Die Folie besteht aus einem desinfektionsbeständigen Material und weist eine glatte, leicht zu reinigende Oberfläche auf. Zum anderen ist die Folie 13 so gestaltet, dass sie an den Stellen, an denen die Tasten 8 vorgesehen sind, so durchleuchtbar ist, dass die Symbole, die den Bedienfunktionen der Tasten 8 zugeordnet sind, sichtbar sind, und dass sie auch später beschriebene Funktionen der Tasten 8 übernimmt.

In Fig. 3 auf der linken Seite dargestellt, ist ein transparentes Fenster 26 in der Folie 13 für den Touchscreen 9 vorgesehen.

Die Schaltmatte 14 ist aus einem Elastomer hergestellt, der durchleuchtbar ist. Die Elastomer-Schaltmatte 14 weist an den jeweiligen Stellen, an denen in der Fernbedienung Tasten 8 vorgesehen sind, ein Tasterbereich 18 als eine Erhöhung auf. Auf der Unterseite der Elastomer-Schaltmatte 14 sind später gezeigte Schließkontakte vorgesehen.

Die Leiterplatte 15 besteht aus einem handelsüblichen Material und ist auf der Oberseite an den Stellen, an denen die Tasten 8 vorgesehen sind, jeweils mit zwei Kontaktflächen 16 versehen. Die Kontaktflächen 16 sind jeweils zahnstangen-förmig ausgebildet und greifen mit einem geringem Abstand dazwischen verzahnt ineinander, wobei eine der Kontaktflächen 16 mit einer größeren Fläche ausgebildet ist, um eine Sensorfläche für ein weiteres Schaltelemente zu bilden. Alternativ können auch mehrere Kontaktflächen pro Taste 8 vorgesehen sein. Die Kontaktflächen 16 sind hier aus Kupfer oder alternativ aus einem anderen geeigneten Material hergestellt. An der Leiterplatte 15 sind der Lage-/Beschleunigungssensor 11 und eine Auswertevorrichtung 17 für die Schaltvorrichtung 1 vorgesehen. Der Lage-/Beschleunigungssensor 11 kann auch in einer anderen Position in der Fernbedienung vorgesehen sein.

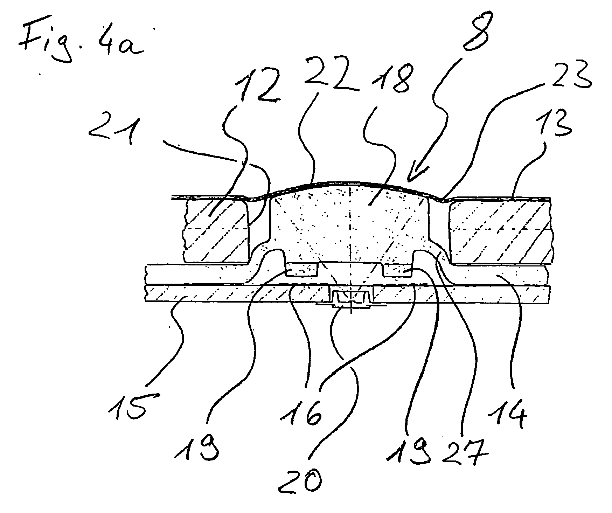

Fig. 4a zeigt die Taste 8 in einem Abschnitt eines Querschnitts durch die in Fig. 3 gezeigte Schnittlinie A-A.

Die Taste 8 wird grundsätzlich aus der Folie 13, dem Tasterbereich 18 der Elastomer-Schaltmatte 14 mit den Schließkontakten 19 und der Leiterplatte 15 mit den Kontaktflächen 16 gebildet.

Die Folie 13 ist so gestaltet, dass sie an der Stelle der Taste 8 eine sphärische Erhöhung 22 aufweist. Die sphärische Erhöhung 22 ist über einen im Querschnitt entgegengesetzt zu der sphärischen Erhöhung gekrümmten Rand 23 mit dem Umgebungsbereich der Folie 13 verbunden. Der Umgebungsbereich der Folie 13 ist mit der Oberschale 12 verbunden. Durch diese Ausbildung der sphärischen Erhöhung 22 und des gekrümmten Rands 23, und durch die Auswahl des Materials der Folie 13 wird bei einem Eindrücken der sphärischen Erhöhung 22 die Folie radial um die sphärische Erhöhung 22 in einen Spannungszustand versetzt, so dass die sphärische Erhöhung bei einem weiteren Eindrücken nach unten schnappt, so dass der Effekt eines "Knackfroschs" entsteht und der Bediener eine taktile Rückmeldung der Betätigung der Taste 8 erhält. Beim Loslassen des sphärischen Bereichs 22 der Taste 8 erfolgt ein selbständiges Rückstellen in die dargestellte Position.

Durch das Nachuntendrücken der sphärischen Erhöhung 22 wird auch der Tasterbereich 18 der Elastomer-Schaltmatte 14 nach unten gedrückt. Dies ist durch die geeignete Ausbildung eines Übergangsbereichs 27 zwischen dem Tasterbereich 18 und dem Umgebungsbereich der Schaltmatte 14 möglich. Der Querschnitt des Übergangsbereichs 27 ist gegenüber dem Umgebungsbereich der Elastomer-Schaltmatte verringert und radial zum Zentrum der Taste 8 in Richtung einer Oberseite der Schaltmatte 14 geneigt. Der Übergangsbereich 27 ist im Bereich des Anschlusses zu dem Tasterbereich 18 hin gekrümmt. Durch diese Ausbildung des Übergangsbereichs 27 kann sich der Tasterbereich 18 nach unten bewegen wenn die sphärische Erhöhung 22 der Folie 13 gedrückt wird. Diese Ausbildung des Übergangsbereiches 27 ist vorzugsweise so gestaltet, dass durch die Schaltmatte 14 keine Störung des taktilen Verhaltens der Tasterbetätigung erfolgt. In einer alternativen Ausführungsform der Schaltvorrichtung 1 kann durch eine andere Gestaltung des Übergangsbereiches 27 jedoch gerade die Schaltmatte 14 ein gewünschtes alleiniges taktiles Verhalten der Tasterbetätigung erzeugen. Hierdurch ließe sich z. B. ein zweistufiges taktiles Verhalten der Taste 8, zuerst durch die Folie 13 und anschließend durch die Schaltmatte 14, erzeugen.

An der Unterseite des Tasterbereichs 18 sind zwei Schließkontakte 19 vorgesehen. Die Schließkontakte 19 sind hier im Schnitt dargestellt und erstrecken sich senkrecht zur Zeichnungsebene, um die zwei verzahnten Kontaktflächen 16 zu verbinden. Die Schließkontakte 19 sind hier vergoldet. Alternativ können sie auch aus einem anderen geeigneten Material hergestellt sein, oder damit überzogen sein. Die Elastomer-Schaltmatte 14 ist aus Silikon hergestellt, kann aber alternativ auch aus einem anderen geeigneten Material hergestellt sein. Das Material der Elastomer-Schaltmatte 14 ist für Licht durchlässig, so dass die Elastomer-Schaltmatte 14 als Lichtleiter dienen kann.

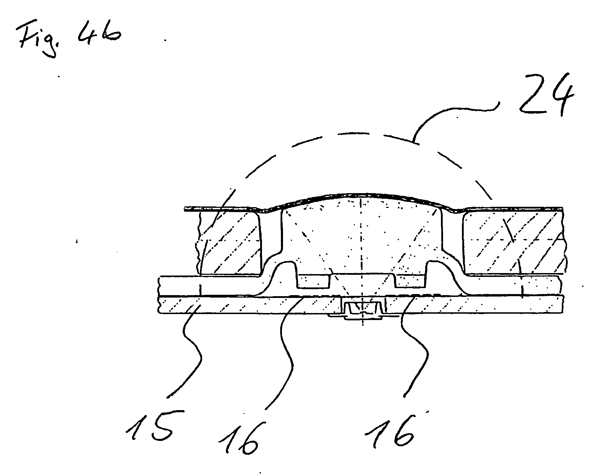

Die Leiterplatte 15 ist so in dem Gehäuse der Fernbedienung angebracht, dass die Schaltmatte 14 zwischen der Leiterplatte 15 und der Oberschale 12 angeordnet ist. Die Leiterplatte 15 weist auf einer Oberseite die Kontaktflächen 16 auf. Die Kontaktflächen 16 sind in Fig. 4 in der Schnittdarstellung dargestellt, erstrecken sich aber in einer Richtung senkrecht zur Zeichnungsebene, wobei bei einem Niederdrücken des Tasterbereichs 18 diese Kontaktflächen 16 durch die Schließkontakte 19 verbunden werden, um den Schaltvorgang der Taste 8 auszuführen.

Die Kontaktflächen 16 wirken weiterhin als Sensoren für ein später beschriebenes zweites Schaltelement.

Die Leiterplatte 15 ist jeweils zentral unter den Tasten 8 mit einer Bohrung versehen, in der ein Leuchtmittel 20, hier in Form einer Leuchtdiode, vorgesehen ist. Das Leuchtmittel 20 wird, wie oben beschrieben, aktiviert, wenn die Bedienfunktion, die durch die jeweilige Taste ausgeführt wird, verfügbar ist. Das ausgestrahlte Licht des Leuchtmittels 20 strahlt durch die durchleuchtbare Elastomer-Schaltmatte 14, wobei der Tasterbereich 18 als Lichtleiter wirkt, und das in der sphärischen Erhöhung 22 eingebrachte Symbol, das als durchscheinender Bereich in der Folie 13 vorgesehen ist, lässt das jeweilige Symbol erkennen.

Der Durchmesser des Durchgangslochs 21 ist mit dem Durchmesser des Tasterbereichs 18 so abgestimmt, dass sein Durchmesser im Wesentlichen dem äußeren Durchmesser des Übergangsbereichs 27 entspricht, um den Tasterbereich 18 eine definierte Führung bereitzustellen, ohne die Beweglichkeit des Tasterbereichs 18 einzuschränken.

Die Schaltmatte 14 mit den Schließkontakten 19, die Leiterplatte 15 mit den Kontakten und die Folie 13 mit der sphärischen Erhöhung 22 bilden ein erstes Schaltelement, das auf dem Schaltprinzip eines elektromechanischen Schalters funktioniert.

In der Schaltvorrichtung 1 ist auch ein zweites Schaltelement vorgesehen, das auf dem Schaltprinzip eines Annäherungsschalters funktioniert. In Fig. 4b sind die Kontaktflächen 16 gezeigt, wobei die Kontaktfläche mit der größeren Fläche (nicht gezeigt) und eine weitere leitende Fläche auf der Leiterplatte 15 in unmittelbarer Nähe der Kontaktflächen 16 als Elektroden für einen kapazitiven Sensor dienen. Durch die Kontaktflächen 16 als Sensorflächen wird ein Erfassungsraum 24 gebildet, der sich oberhalb der Kontaktflächen 16 erstreckt. In dem Erfassungsraum 24 wird ein elektrisches Feld aufgebaut, und es wird erkannt, wenn ein dielektrischer Gegenstand, z.B. ein Finger, in den Erfassungsraum 24 eingebracht wird. Die Kontaktfläche 16 bildet gemeinsam mit der weiteren leitenden Fläche und der Auswertevorrichtung 17 das zweite Schaltelement.

Alternativ zu einem kapazitiven Sensor kann der Annäherungsschalter auch auf einem anderen Schaltprinzip basieren. Denkbar sind hier z.B. Thermosensoren zum Erfassen einer Wärmestrahlung, Mikrofone zum Erfassen von Geräuschen, z.B. Spracheingabe, oder optische Sensoren. Der Vorteil eines kapazitiven Sensors ist, dass elektromagnetische Felder und statische Aufladungen anhand spezifischer Muster erkannt und unterdrückt werden können.

Die Darstellung des Erfassungsraums 24 ist in Fig. 4b nur prinzipiell als ein einzelner Erfassungsraum 24 dargestellt. Der gesamte Erfassungsraum wird in dieser Ausführungsform durch eine Kombination einzelner Erfassungsräume 24, die durch die Kontaktflächen 16 von hier fünf aneinander liegenden Tasten 8 gebildet werden, gebildet. Die Anzahl der kombinierten einzelnen Erfassungsräume 24, durch die der gesamte Erfassungsraum gebildet wird, kann in alternativen Ausführungsformen zwischen einem einzelnen Erfassungsraum 24 pro Taste 8 und einem kombinierten Erfassungsraum für sämtliche Tasten 8 liegen. Für weitere Funktionalitäten ist es jedoch günstig, wenn mindestens zwei einzelne Erfassungsräume, die nicht kombiniert sind, oder mindestens zwei gesamte Erfassungsräume als Kombination von einzelnen Erfassungsräumen 24 vorhanden sind.

Das zweite Schaltelement ist so angepasst, dass grundsätzlich die Anwesenheit eines Betätigungsobjekts in dem Erfassungsraum 24 erfasst wird. Darüber hinaus ist das zweite Schaltelement auch in der Lage, einen Abstand des Betätigungsobjekts von den Kontakten 16 zu erkennen. Die Auswertevorrichtung 17 ist so angepasst, dass es möglich ist, über die Erfassung eines Abstands zwischen dem Betätigungselement und den Kontaktflächen 16 mit dem zweiten Schaltelement zu erkennen, ob sich das Betätigungselement lediglich in dem Erfassungsraum 24 befindet, ob durch das Betätigungselement eine der Tasten 8, die in dem Erfassungsraum 24 angeordnet ist, berührt wird, oder ob eine der Tasten 8, die in dem Erfassungsraum 24 angeordnet ist, betätigt wird.

Im Betrieb befindet sich die Schaltvorrichtung 1, falls sie als eine drahtlose Fernbedienung ausgebildet ist, in einem Standby-Zustand, um die Energiespeicher in der Fernbedienung nicht unnötig zu entladen. Falls die Schaltvorrichtung 1 über Kabel mit dem Medizingerät 2 verbunden ist, kann diese ständig aktiv sein.

Die Schaltvorrichtung 1 als drahtlose Fernbedienung wird durch Einbringen eines Betätigungsobjekts, z.B. einer Hand, in mindestens zwei Erfassungsräume 24 der zweiten Schaltelemente aktiviert. In einer alternativen Ausführungsform ist es, wie oben beschrieben, auch möglich, die Fernbedienung durch eine von dem Lage-/Beschleunigungssensor erfasste Bewegung zu aktivieren. Ein Aktivieren durch Einbringen eines Betätigungsobjekts in nur einen Erfassungsraum 24 erfolgt nicht, da hier die Gefahr einer ungewollten Aktivierung, beispielsweise durch Darauffallen eines medizinischen Instruments groß ist.

Das Schalten einer Bedienfunktion des medizinischen Geräts 2 wird so angesteuert, dass zunächst das zweite Schaltelement, das der entsprechenden Taste 8 für die gewünschte Bedienfunktion zugeordnet ist, ein Annähern des Betätigungsobjekts erkennt, und dabei die dem zweiten Schaltelement zugeordnete(n) Taste(n) mit dem(/n) ersten Schaltelement(en) freischaltet. Im nächsten Schritt wird eine der freigeschalteten Taste in dem Erfassungsraum 24 des ersten Schaltelements betätigt, und die Schaltvorrichtung 1 gibt an die Steuerungsvorrichtung 3 des medizinischen Geräts 2 den Befehl, die entsprechende Bedienfunktion auszuführen.

Falls zwei Tasten 8 in einem Erfassungsraum 24 betätigt werden, gibt die Steuerungsvorrichtung 1 eine Fehlermeldung aus und keine der Funktionen wird ausgeführt.

Da das zweite Schaltelement nicht nur erkennen kann, ob sich das Betätigungsobjekt in dem Erfassungsraum 24 befindet, sondern auch, ob sich das Betätigungsobjekt in Positionen befindet, in der es eine Taste 8 in dem Erfassungsraum 24 berührt oder betätigt, erkennt die Auswertevorrichtung 17, ob das erste Schaltelement dahingehend fehlerhaft ist, dass es eine Bedienfunktion nicht schaltet, obwohl die zugehörige Taste 8 betätigt ist, oder ob ein erstes Schaltelement eine Bedienfunktion schaltet, obwohl es über die Taste 8 nicht betätigt ist. In beiden Fällen wird durch die Auswertevorrichtung 17 kein Schaltbefehl für die Bedienfunktion ausgegeben, und eine Fehlermeldung wird sofort beim Erkennen eines Fehlers ausgegeben.

Als eine weitere Sicherheitsfunktion kann vorgesehen sein, dass die als Fernbedienung ausgebildete Schaltvorrichtung 1 über die Auswertevorrichtung 17 keine Schaltsignale ausgibt, wenn sie über den Lage-/Beschleunigungssensor der Fernbedienung erkennt, dass die Fernbedienung so orientiert ist, dass die Tasten 8 nach unten zeigen, da hier von einem fehlerhaften Betätigen ausgegangen werden kann.

Des Weiteren verfügt das zweite Schaltelement über eine automatische Nachkalibrierung Bei dieser zyklischen Nachkalibrierung wird die Empfindlichkeit der Sensoren neu eingestellt. Ziel der Nachkalibrierung ist, die Empfindlichkeit der Sensoren auch unter verschiedenen Betriebsbedingungen konstant zu halten. So ist beispielsweise auch eine zuverlässige Funktion der Schaltvorrichtung 1 gegeben, wenn sich in der Umgebung ein Gerät, das eine hohe elektrische Strahlung abgibt, wie z.B. ein in Betrieb befindliches Hochfrequenz-Chirurgiegerät, befindet. Hier ist durch die Nachkalibrierung zum einen die zuverlässige beabsichtigte Funktion der Schaltvorrichtung, als auch ein Vermeiden von nicht beabsichtigten Schaltvorgängen gewährleistet.

## Patentansprüche

1. Schaltvorrichtung (1) zum Erreichen einer Erstfehlersicherheit für ein medizinisches Gerät (2) mit
mindestens einem ersten Schaltelement, durch das eine zugeordnete Bedienfunktion schalbar ist, und mindestens einem zweiten Schaltelement, durch das eine Schaltfunktion des mindestens einen ersten Schaltelements freigebbar ist, wobei das Schalten der Schaltelemente auf zwei verschiedenen Schaltprinzipien beruht,
wobei
das zweite Schaltelement so angepasst ist, dass es einen Erfassungsraum (24) aufweist, in dem es eine Anwesenheit eines Betätigungsobjekts erfasst,
und mindestens eines der ersten Schaltelemente in dem Erfassungsraum (24) von mindestens einem der zweiten Schaltelemente angeordnet ist,
wobei jedem ersten Schaltelement mindestens ein zweites Schaltelement zugeordnet ist, indem das erste Schaltelement in dem Erfassungsraum (24) des zweiten Schaltelements angeordnet ist, und eine Auswertevorrichtung (17) vorgesehen ist, die die Bedienfunktion des ersten Schaltelements schaltet, wenn sowohl das erste Schaltelement als auch das zugeordnete zweite Schaltelement durch das Betätigungsobjekt betätigt ist,
**dadurch gekennzeichnet, dass**
die Auswertevorrichtung (17) zur Auswertung von Schaltsignalen so ausgebildet ist, dass die Auswertevorrichtung (17) über ein Signal des zweiten Schaltelements erkennt, wenn das Betätigungsobjekt in einer Position ist, in der es das erste Schaltelement betätigt.

2. Schaltvorrichtung (1) gemäß Anspruch 1, **dadurch gekennzeichnet, dass** mindestens zwei zweite Schaltelemente vorgesehen sind.

3. Schaltvorrichtung (1) gemäß Anspruch 1 oder 2, **dadurch gekennzeichnet, dass** jedem ersten Schaltelement genau ein zweites Schaltelement zugeordnet ist.

4. Schaltvorrichtung (1) gemäß einem der vorangehenden Ansprüche, **dadurch gekennzeichnet, dass** das erste Schaltelement ein elektro-mechanischer Schalter ist.

5. Schaltvorrichtung (1) gemäß einem der vorangehenden Ansprüche, **dadurch gekennzeichnet, dass** das zweite Schaltelement ein Annäherungsschalter ist.

6. Schaltvorrichtung (1) gemäß Anspruch 5, **dadurch gekennzeichnet, dass** das zweite Schaltelement ein kapazitiver Sensor ist.

7. Schaltvorrichtung (1) gemäß einem der vorangehenden Ansprüche, **dadurch gekennzeichnet, dass** das erste Schaltelement und das zweite Schaltelement gemeinsame Funktionsteile aufweisen.

8. Schaltvorrichtung (1) gemäß Anspruch 7, **dadurch gekennzeichnet, dass** Schaltkontakte (16) des ersten Schaltelements Sensorflächen des zweiten Schaltelements aufweisen.

9. Schaltvorrichtung (1) gemäß einem der vorangehenden Ansprüche, **dadurch gekennzeichnet, dass** die Auswertevorrichtung (17) so ausgebildet ist, dass die Auswertevorrichtung (17) ein Fehlersignal ausgibt wenn die Auswertevorrichtung (17) über ein Signal des zweiten Schaltelements erkennt, dass das erste Schaltelement betätigt ist, aber das erste Schaltelement kein Schaltsignal an die Auswertevorrichtung (17) gibt.

10. Schaltvorrichtung (1) gemäß einem der vorangehenden Ansprüche, **dadurch gekennzeichnet, dass** die Schaltvorrichtung (1) eine Fernbedienung für ein medizinisches Gerät (2) ist.

11. Schaltvorrichtung (1) gemäß Anspruch 10, **dadurch gekennzeichnet, dass** die Fernbedienung einen Lagesensor (11) und eine Auswertevorrichtung (17) zur Erkennung der Orientierung der Fernbedienung aufweist.

12. Schaltvorrichtung (1) gemäß Anspruch 10 oder 11, **dadurch gekennzeichnet, dass** die Fernbedienung mehrere zweite Schaltelemente aufweist, und die Fernbedienung so ausgebildet ist, dass sie aktiviert wird, wenn die Auswertevorrichtung (17) Schaltsignale für eine gleichzeitige Betätigung von mehreren zweiten Schaltelementen erkennt.

13. Schaltvorrichtung (1) gemäß einem der Ansprüche 10 bis 12, **dadurch gekennzeichnet, dass** das medizinische Gerät (2) ein Operationstisch ist.

14. Medizinisches Gerät (2) mit einer Schaltvorrichtung (1) gemäß einem der Ansprüche 1 bis 13.

15. Verfahren zum Betrieb einer Schaltvorrichtung (1) gemäß einem der Ansprüche 1 bis 13, **dadurch gekennzeichnet, dass**
ein Betätigungsobjekt der Schaltvorrichtung (1) angenähert wird,
in einem ersten Schritt das zweite Schaltelement die Anwesenheit des angenäherten Betätigungsobjekts in dem Erfassungsraum erkennt und das/die zugeordneten ersten Schaltelement(e) freigeschaltet wird, und
in einem zweiten Schritt das Betätigungsobjekt das erste Schaltelement in dem Erfassungsraum des zugeordneten zweiten Schaltelements betätigt, so dass die durch das erste Schaltelement zu schaltende Bedienfunktion geschaltet wird,
**dadurch gekennzeichnet, dass** in dem zweiten Schritt die Position des Betätigungsobjekts, in der es das erste Schaltelement betätigt, durch das zweite Schaltelement erkannt wird.

16. Verfahren gemäß Anspruch 15, **dadurch gekennzeichnet, dass** die Auswertevorrichtung (17) ein Fehlersignal ausgibt, wenn in dem zweiten Schritt die Position des Betätigungsobjekts, in der es das erste Schaltelement tatsächlich betätigt, erkannt wird, das erste Schaltelement aber nicht schaltet, oder das erste Schaltelement geschaltet ist, obwohl kein Betätigungsobjekt in der Position, in der es das erste Schaltelement betätigt, erkannt wird.

17. Verfahren gemäß einem der Ansprüche 15 oder 16, **dadurch gekennzeichnet, dass** die Schaltvorrichtung (1) aktiviert wird, wenn in dem zweiten Schritt mehrere zweite Schaltelemente die Annäherung des Betätigungsobjekts erkennen.

18. Verfahren gemäß einem der Ansprüche 15 bis 17, **dadurch gekennzeichnet, dass** die Schaltvorrichtung (1) die Fernbedienung ist, und die Auswertevorrichtung (17) keine Schaltsignale ausgibt, wenn die Auswertevorrichtung (17) über den Lagesensor (11) der Fernbedienung erkennt, dass die Fernbedienung so orientiert ist, dass die Tasten (8) nach unten zeigen.

## Claims

1. Switching device (1) for achieving a first fault safety for a medical apparatus (2) with
at least one first switching member adapted to switch an assigned operating function and at least one second switching member adapted to release a switching function of the at least first switching member, wherein the switching of the switching members is based on two different switching principles, wherein
the second switching member is adapted such that it has a detection space (24) in which it detects a presence of an operating object,
and at least one of the first switching members is arranged in the detection space (24) of at least one of the second switching members, wherein
at least one second switching member is assigned to each first switching member as the first switching member is arranged in the detection space (24) of the second switching member and an evaluation device (17) switching the operating function of the first switching member when the first switching member as well as the assigned second switching member are operated by the operating object is provided,
**characterized in that**
the evaluation device (17) for evaluating switching signals is configured such that the evaluation device (17) recognizes by a signal of the second switching member when the operating object is in a position in which it operates the first switching member.

2. Switching device (1) according to claim 1, **characterized in that** at least two second switching members are provided.

3. Switching device (1) according to claim 1 or 2, **characterized in that** exact one second switching member is assigned to each first switching member.

4. Switching device (1) according to any of the preceding claims, **characterized in that** the first switching member is an electro-mechanical switch.

5. Switching device (1) according to any of the preceding claims, **characterized in that** the second switching member is a proximity switch.

6. Switching device (1) according to claim 5, **characterized in that** the second switching member is a capacitive sensor.

7. Switching device (1) according to any of the preceding claims, **characterized in that** the first switching member and the second switching member have common functioning parts.

8. Switching device (1) according to claim 7, **characterized in that** the switching contacts (16) of the first switching members comprise sensor areas of the second switching member.

9. Switching device (1) according to any of the preceding claims, **characterized in that** the evaluation device (17) is configured such that the evaluation device (17) outputs an error signal when the evaluation device (17) recognizes that the first switching member is operated but the first switching member does not give any switch signal to the evaluation device (17) by means of a signal of the second switching member.

10. Switching device (1) according to any of the preceding claims, **characterized in that** the switching device (1) is a remote control for a medical apparatus (2).

11. Switching device (1) according to claim 10, **characterized in that** the remote control comprises a position sensor (11) and an evaluation device (17) for recognizing the orientation of the remote control.

12. Switching device (1) according to claim 10 or 11, **characterized in that** the remote control comprises several second switching members and the remote control is configured such that it is activated when the evaluation device (17) recognizes switching signals for a simultaneous operation of several second switching members.

13. Switching device (1) according to any of claims 10 to 12, **characterized in that** the medical apparatus (2) is a surgical table.

14. Medical apparatus (2) with a switching device (1) according to any of the claims 1 to 13.

15. Method for operating a switching device (1) according to any of the claims 1 to 13, **characterized in that**
an operating object is approached to the switching device (1) ,
in a first step, the second switching member detects the presence of the approached operating object in the detection space and the assigned first switching member(s) is (are) released, and
in a second step, the operating object operates the first switching member in the detection space of the assigned second switching member so that the operating function switched by the first switching member is switched,
**characterized in that**
in the second step, the position of the operating object in which it operates the first switching member is recognized by the second switching member.

16. Method according to claim 15, **characterized in that** the evaluation device (17) outputs an error signal when in the second step, the position of the operating object in which it really operates the first switching member is recognized, however, the first switching member does not switch, or the first switching member is switched although no operating object is recognized in the position in which it operates the first switching member.

17. Method according to any of claims 15 or 16, **characterized in that** the switching device (1) is activated when, in the second step, several second switching members recognize the approach of the operating object.

18. Method according to any of claims 15 to 17, **characterized in that** the switching device (1) is the remote control and the evaluation device (17) does not output any switch signals when the evaluation device (17) recognizes that the remote control is oriented such that the keys (8) point downwards by means of the position sensor (11) of the remote control.

## Revendications

1. Dispositif de commutation (1) destiné à obtenir une protection contre une première erreur pour un appareil médical (2), comportant
au moins un premier élément de commutation, au moyen duquel une fonction de commande correspondante peut être activée, et au moins un deuxième élément de commutation, par lequel une fonction de commutation du ou des premiers éléments de commutation peut être déclenchée, la commutation des éléments de commutation reposant sur deux principes de commutation différents,
où
le deuxième élément de commutation est adapté de manière à comporter un espace de détection (24) où il détecte la présence d'un objet d'activation,
et où au moins un des premiers éléments de commutation est disposé dans l'espace de détection (24) d'au moins un des deuxièmes éléments de commutation,
où, à chaque premier élément de commutation est associé au moins un deuxième élément de commutation, le premier élément de commutation étant disposé dans l'espace de détection (24) du deuxième élément de commutation, et un dispositif d'analyse (17) étant prévu, lequel commute la fonction de commande du premier élément de commutation quand le premier élément de commutation ainsi que le deuxième élément de commutation associé sont activés par l'objet d'activation,
**caractérisé en ce que**
le dispositif d'analyse (17) est réalisé pour l'analyse de signaux de commutation, de telle manière que ledit dispositif d'analyse (17) détecte au moyen d'un signal du deuxième élément de commutation si l'objet d'activation est dans une position où il active le premier élément de commutation.

2. Dispositif de commutation (1) selon la revendication 1, **caractérisé en ce qu'**au moins deux deuxièmes éléments de commutation sont prévus.

3. Dispositif de commutation (1) selon la revendication 1 ou la revendication 2, **caractérisé en ce qu'**à chaque premier élément de commutation est précisément associé un deuxième élément de commutation.

4. Dispositif de commutation (1) selon l'une des revendications précédentes, **caractérisé en ce que** le premier élément de commutation est un commutateur électromécanique.

5. Dispositif de commutation (1) selon l'une des revendications précédentes, **caractérisé en ce que** le deuxième élément de commutation est un commutateur de proximité.

6. Dispositif de commutation (1) selon la revendication 5, **caractérisé en ce que** le deuxième élément de commutation est un capteur capacitif.

7. Dispositif de commutation (1) selon l'une des revendications précédentes, **caractérisé en ce que** le premier élément de commutation et le deuxième élément de commutation comportent des pièces fonctionnelles communes.

8. Dispositif de commutation (1) selon la revendication 7, **caractérisé en ce que** des contacts de commutation (16) du premier élément de commutation comportent des surfaces de capteur du deuxième élément de commutation.

9. Dispositif de commutation (1) selon l'une des revendications précédentes, **caractérisé en ce que** le dispositif d'analyse (17) est réalisé de telle manière que ledit dispositif d'analyse (17) émet un signal d'erreur quand ledit dispositif d'analyse (17) détecte au moyen d'un signal du deuxième élément de commutation que le premier élément de commutation est activé, mais que le premier élément de commutation ne délivre aucun signal de commutation au dispositif d'analyse (17).

10. Dispositif de commutation (1) selon l'une des revendications précédentes, **caractérisé en ce que** ledit dispositif de commutation (1) est une télécommande pour un appareil médical (2).

11. Dispositif de commutation (1) selon la revendication 10, **caractérisé en ce que** la télécommande comporte un capteur de position (11) et un dispositif d'analyse (17) pour la détection d'orientation de la télécommande.

12. Dispositif de commutation (1) selon la revendication 10 ou la revendication 11, **caractérisé en ce que** la télécommande comporte plusieurs deuxièmes éléments de commutation, et **en ce que** la télécommande est réalisée de manière à être activée si le dispositif d'analyse (17) détecte des signaux de commutation pour une activation simultanée de plusieurs deuxièmes éléments de commutation.

13. Dispositif de commutation (1) selon l'une des revendications 10 à 12, **caractérisé en ce que** l'appareil médical (2) est une table d'opération.

14. Appareil médical (2) comportant un dispositif de commutation (1) selon l'une des revendications 1 à 13.

15. Procédé de fonctionnement d'un dispositif de commutation (1) selon l'une des revendications 1 à 13, **caractérisé**
**en ce qu'**un objet d'activation du dispositif de commutation (1) est rapproché,
dans une première étape, le deuxième élément de commutation détecte la présence de l'objet d'activation rapproché dans l'espace de détection et les ou les premiers éléments de commutation sont déclenchés, et
dans une deuxième étape, l'objet d'activation active le premier élément de commutation dans l'espace de détection du deuxième élément de commutation associé, de manière à commuter la fonction de commande à commuter par le premier élément de commutation,
**caractérisé en ce qu'**en deuxième étape, la position de l'objet d'activation où celui-ci active le premier élément de commutation est détectée par le deuxième élément de commutation.

16. Procédé selon la revendication 15, **caractérisé en ce que** le dispositif d'analyse (17) émet un signal d'erreur si, en deuxième étape, la position de l'objet d'activation où celui-ci active effectivement le premier élément de commutation, est détectée, mais sans commutation du premier élément de commutation, ou si le premier élément de commutation est commuté bien qu'aucun objet d'activation ne soit détecté dans la position où il active le premier élément de commutation.

17. Procédé selon la revendication 15 ou la revendication 16, **caractérisé en ce que** le dispositif de commutation (1) est activé si, en deuxième étape, plusieurs deuxièmes éléments de commutation détectent le rapprochement de l'objet d'activation.

18. Procédé selon l'une des revendications 15 à 17, **caractérisé en ce que** le dispositif de commutation (1) est la télécommande, et **en ce que** le dispositif d'analyse (17) n'émet pas de signaux de commutation si le dispositif d'analyse (17) détecte au moyen du capteur de position (11) de la télécommande que ladite télécommande est orientée de telle manière que les touches (8) sont dirigées vers le bas.
